(19) **Europäisches Patentamt / European Patent Office / Office européen des brevets**

(11) **EP 4 746 610 A1**

(12) **EUROPEAN PATENT APPLICATION**
published in accordance with Art. 153(4) EPC

(43) Date of publication:
20.05.2026 Bulletin 2026/21

(21) Application number: 24856133.4

(22) Date of filing: 27.06.2024

(51) International Patent Classification (IPC):
$H05K\ 9/00^{(2006.01)}$  $B22F\ 10/00^{(2021.01)}$
$B29C\ 64/112^{(2017.01)}$  $B29C\ 64/118^{(2017.01)}$
$B29C\ 64/124^{(2017.01)}$  $B29C\ 64/153^{(2017.01)}$
$B33Y\ 10/00^{(2015.01)}$  $B33Y\ 40/20^{(2020.01)}$
$G01J\ 1/02^{(2006.01)}$  $H01Q\ 17/00^{(2006.01)}$

(52) Cooperative Patent Classification (CPC):
B22F 10/00; B29C 64/112; B29C 64/118;
B29C 64/124; B29C 64/153; B33Y 10/00;
B33Y 40/20; G01J 1/02; H01Q 17/00; H05K 9/00

(86) International application number:
PCT/JP2024/023334

(87) International publication number:
WO 2025/041438 (27.02.2025 Gazette 2025/09)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 18.08.2023 JP 2023133366

(71) Applicant: National Institute of Advanced
Industrial
Science and Technology
Chiyoda-ku
Tokyo 100-8921 (JP)

(72) Inventors:
• KUWANO Genki
  Tsukuba-shi, Ibaraki 305-8560 (JP)
• KURIHARA Kazuma
  Tsukuba-shi, Ibaraki 305-8560 (JP)
• HOKARI Ryohei
  Tsukuba-shi, Ibaraki 305-8560 (JP)
• TOJIMA Yuya
  Tsukuba-shi, Ibaraki 305-8560 (JP)
• KINOSHITA Moto
  Tsukuba-shi, Ibaraki 305-8560 (JP)

(74) Representative: Hasegawa, Kan
Patentanwaltskanzlei Hasegawa
Untere Hauptstraße 56
85354 Freising (DE)

(54) **ELECTROMAGNETIC WAVE ABSORBER AND METHOD FOR MANUFACTURING SAME**

(57) The present disclosure can provide an electromagnetic wave absorber capable of achieving both a high absorption rate and thermal responsiveness and a method for manufacturing the electromagnetic wave absorber. An electromagnetic wave absorber according to one embodiment of the present disclosure includes: a hollow structure having a bottom surface portion; and a heat conductive layer continuously formed from an outer surface of the hollow structure to the bottom surface portion.

FIG. 1A

(Cont. next page)

FIG. 1B

**Description**

Technical Field

The present disclosure relates to an electromagnetic wave absorber and a method of manufacturing the same.

Background Art

An electromagnetic wave absorber that absorbs electromagnetic waves is used for various applications. The electromagnetic wave absorber is a substance that absorbs incident electromagnetic waves by converting the electromagnetic waves into thermal energy by any of conductor loss, dielectric loss, or magnetic loss. In order to improve the absorption performance of the electromagnetic wave absorber, it is necessary to reduce an interface reflection component caused by a difference between a complex refractive index of air and a complex refractive index of a substance.

In order to reduce a reflectivity as low as possible and improve the absorption performance, various techniques have been developed (see Patent Literatures (hereinafter, referred to as "PTLs") 1 to 5).

Citation List

Patent Literature

PTL 1
Japanese Patent Application Laid-Open No.2022-32341
PTL 2
Japanese Patent Application Laid-Open No.2014-187134
PTL 3
Japanese Patent No. 5606572
PTL 4
Japanese Patent Application Laid-Open No. 2015-95638
PTL 5
Japanese Patent No. 6877770

Summary of Invention

Technical Problem

The electromagnetic wave absorber is used for a power meter that measures an absolute value of an intensity of electromagnetic waves. In particular, in order to realize a next-generation information and communication system using electromagnetic waves of 100 GHz or more and 300 GHz or less, there is a strong demand for realizing a power meter capable of measuring electromagnetic waves in a millimeter wave and terahertz wave frequency band.

Examples of performance characterizing the power meter include measurement accuracy and response speed. The power meter is mainly composed of an electromagnetic wave absorber and a thermoelectric conversion section (thermal detection section), and one of the dominant elements determining the measurement accuracy is an absorption rate of the electromagnetic wave absorber. On the other hand, the response speed depends on a thermal responsiveness of the electromagnetic wave absorber. Therefore, there is a demand for an electromagnetic wave absorber that achieves both the absorption rate and the thermal responsiveness.

Objectives of the present disclosure include providing an electromagnetic wave absorber that can achieve both a high absorption rate and thermal responsiveness, and a method of manufacturing the same.

Solution to Problem

An electromagnetic wave absorber according to one aspect of the present disclosure includes: a hollow structure having a bottom surface portion; and a heat conductive layer continuously formed from an outer surface of the hollow structure to the bottom surface portion.

A method of manufacturing an electromagnetic wave absorber according to one aspect of the present disclosure includes: forming a hollow structure having a bottom surface portion by using a 3D printer; and continuously forming a heat conductive layer from an outer surface of the hollow structure to the bottom surface portion, in which a shaping method using the 3D printer is at least any one of a fused deposition modeling method, an stereolithography method, a powder sintering method, and a material jetting method.

Advantageous Effects of Invention

According to the present disclosure, it is possible to achieve both a high absorption rate and thermal responsiveness.

Brief Description of Drawings

FIG. 1A is a diagram showing an example of an appearance of an electromagnetic wave absorber of the first exemplary configuration, and FIG. 1B is a cross-sectional view (part) of the electromagnetic wave absorber in a plane perpendicular to an xy plane including vertices of a plurality of periodic structures;
FIGS. 2A to 2C are graphs showing a film thickness dependence of a transmittance, a reflectivity, and an absorption rate in a case where electromagnetic waves are perpendicularly incident on a metal thin film having a length equal to or less than an electromagnetic shielding length, in which FIG. 2A shows a graph in a case of $\rho$ = 0.1 $\mu\Omega$m, FIG. 2B shows a graph in a case of $\rho$ = 1 $\mu\Omega$m, and FIG. 2C shows a graph in a case of $\rho$ = 10 $\mu\Omega$m;
FIG. 3 is a cross-sectional view showing an example in which a metal plate is provided on a bottom surface side of the electromagnetic wave absorber;
FIG. 4A is a perspective view of an electromagnetic wave absorber of a second exemplary configuration, and FIG. 4B is a top view of the electromagnetic wave absorber of the second exemplary configuration;
FIG. 5A is a perspective view of the electromagnetic wave absorber in a case where the periodic structure has a hexagonal prism shape, and FIG. 5B is a top view of the electromagnetic wave absorber in a case where the periodic structure has the hexagonal prism shape;
FIG. 6A is a perspective view of an electromagnetic wave absorber of a third exemplary configuration, and FIG. 6B is a top view of the electromagnetic wave absorber of the third exemplary configuration;
FIG. 7A is a diagram showing an example of an electromagnetic wave absorber of a fourth exemplary configuration, and FIG. 7B is a diagram showing another example of the electromagnetic wave absorber of the fourth exemplary configuration;
FIGS. 8A to 8C are conceptual diagrams for describing a mechanism in which the thermal responsiveness is improved by a heat conductive layer continuously formed on a surface of a structure, in which FIG. 8A is a diagram showing a structure in which the heat conductive layer is formed on a surface of a resin layer, FIG. 8B is a diagram showing a case where the structure is locally irradiated with electromagnetic waves from a resin layer side, and FIG. 8C is a diagram showing a case where the structure is irradiated with electromagnetic waves from a heat conductive layer side;
FIG. 9 is a diagram showing a spectrum and a noise level of a reflected pulse signal measured by placing a gold mirror on a placement table on which the electromagnetic wave absorber is placed;
FIG. 10 is a schematic diagram of a measurement system used for evaluating the thermal responsiveness;
FIGS. 11A and 11B are diagrams showing an optical microscope image of Sample 1, in which FIG. 11A is a diagram showing a state before a heat conductive layer is formed, and FIG. 11B is a diagram showing a state after Ni-P plating is formed as the heat conductive layer;
FIG. 12 is a graph showing reflection characteristics of Sample 1 before and after the heat conductive layer is formed;
FIGS. 13A and 13B are graphs showing thermal responsiveness characteristics of Sample 1 before and after the heat conductive layer is formed, in which FIG. 13A is a graph showing a relationship between a film thickness of the heat conductive layer and a temperature rise, and FIG. 13B is a graph in which a vertical axis is divided by a maximum temperature rise value;
FIG. 14A is a diagram showing a photograph of a comparative example 1, and FIG. 14B is a diagram showing a photograph of Sample 1;
FIG. 15 is a diagram showing a measurement result of an infrared emissivity of the comparative example 1;
FIG. 16 is a diagram showing a measurement result of a reflectivity obtained by time-domain spectroscopy;
FIG. 17A is a diagram showing a snapshot during an infrared camera measurement of Sample 1, and FIG. 17B is a diagram showing a snapshot during an infrared camera measurement of the comparative example 1;
FIG. 18 is a diagram in which a time change in a temperature rise in a center portion of Sample 1 and the comparative example 1 is plotted;
FIGS. 19A and 19B are diagrams showing an optical microscope image of Sample 2, in which FIG. 19A is a diagram showing a state before a heat conductive layer is formed, and FIG. 19B is a diagram showing a state after Ni-P plating is formed as the heat conductive layer;

EP 4 746 610 A1

FIG. 20 is a diagram showing a frequency dependence of a reflectivity of Sample 2 after the heat conductive layer having a thickness of 132 nm is formed;
FIG. 21 is a diagram showing a time response in a case where a maximum temperature rise value is set to 1 for Sample 2 before and after the heat conductive layer is formed;
FIGS. 22A and 22B are diagrams showing an optical microscope image of a sample 3, in which FIG. 22A is a diagram showing a state before a heat conductive layer is formed, and FIG. 22B is a diagram showing a state after Ni-P plating is formed as the heat conductive layer;
FIGS. 23A and 23B are diagrams showing an optical microscope image of a sample 4, in which FIG. 23A is a diagram showing a state before a heat conductive layer is formed, and FIG. 23B is a diagram showing a state after Ni-P plating is formed as the heat conductive layer;
FIGS. 24A and 24B are diagrams showing an optical microscope image of a sample 5, in which FIG. 24A is a diagram showing a state before a heat conductive layer is formed, and FIG. 24B is a diagram showing a state after Ni-P plating is formed as the heat conductive layer; and
FIG. 25 is a diagram summarizing a comparison result between the samples.

Description of Embodiments

Hereinafter, embodiments of the present disclosure will be described in detail with reference to the drawings. However, detailed descriptions, for example, detailed descriptions of matters that are already well known or redundant descriptions for substantially the same configurations may be omitted as necessary.

<First Exemplary Configuration>

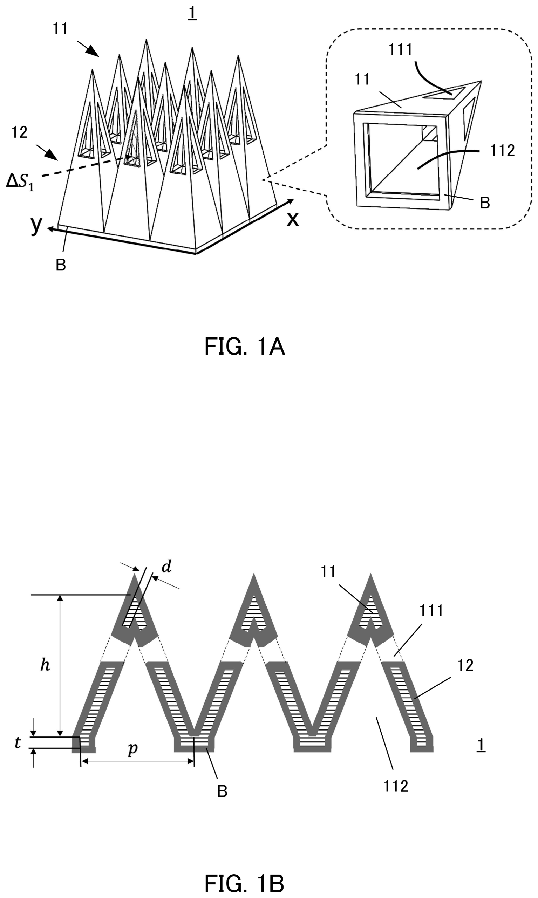

First, a first exemplary configuration of the electromagnetic wave absorber 1 according to the present disclosure will be described. FIGS. 1A and 1B are diagrams for describing the first exemplary configuration of the electromagnetic wave absorber according to the present disclosure.
FIG. 1A is a diagram showing an example of an appearance of the first exemplary configuration of the electromagnetic wave absorber 1 according to the present disclosure. The electromagnetic wave absorber 1 includes hollow periodic structures 11 formed along a predetermined xy plane, and a heat conductive layer 12 that is continuously formed from the outer surfaces of the periodic structures 11 to a bottom surface portion B of the periodic structure 11 through the inner surfaces of the periodic structures 11. In other words, the electromagnetic wave absorber 1 is configured by arranging a plurality of the periodic structures 11 along the xy plane.
In the first exemplary configuration, each of the periodic structures 11 is a square pyramid-shaped structure, and an opening 111 is provided in a side surface of the periodic structure 11. The outer surface of the periodic structure 11 means a square pyramid-shaped side surface, and the inner surface of the periodic structure 11 means a surface constituting a hollow structure provided in the square pyramid-shaped interior. The bottom surface portion B of the periodic structure 11 is disposed on the xy plane. In addition, a space 112 is provided in the periodic structure 11. The electromagnetic wave absorber 1 may be disposed in, for example, an angle range of ±30 degrees with respect to an incidence direction of the electromagnetic waves, but in the present disclosure, the installation angle of the electromagnetic wave absorber is not limited to the angle.
FIG. 1B is a cross-sectional view (part) of the electromagnetic wave absorber 1 in a plane perpendicular to the xy plane including vertices of the plurality of periodic structures 11.
As shown in FIG. 1B, the periodic structures 11 are arranged with the same period p in the x direction and the y direction. In the example shown in FIG. 1B, a width (length along the x direction or the y direction) of the periodic structure 11 for one period is the same length as a period p of one period, but the present disclosure is not limited to this, and for example, the width of the periodic structure 11 may be smaller than the length of the period p. In other words, a gap may be provided between the periodic structures 11 adjacent to each other.
In a case where a minimum wavelength of the electromagnetic waves incident on the electromagnetic wave absorber 1 is denoted by λmin, the length p of one period is expressed by Expression 1:

$$p < 10\lambda min \quad ... \text{(Expression 1)}.$$

λmin < p < 10λmin is referred to as a resonance domain, and in a case where the electromagnetic waves are incident, higher-order diffracted light can be generated.
More preferably, the value of p is expressed by Expression 2:

$$(\lambda min/4) \leq p \leq \lambda min \quad ... \text{(Expression 2)}.$$

5

The part "$p \leq \lambda min$" is referred to as a sub-wavelength region, and it is known that higher-order diffracted light is less likely to be generated in this region. Therefore, from the viewpoint of easily performing a specific evaluation of the electromagnetic wave absorber 1, the period p of the periodic structures 11 is more preferably set in the sub-wavelength region.

More preferably, the period p is expressed by Expression 3:

$$p = (\lambda min/4) \qquad ... \text{(Expression 3)}.$$

For example, in a case where the minimum wavelength is 3 mm (highest frequency of 100 GHz), the more preferable value of the period p is 750 $\mu$m.

In a case where the electromagnetic wave absorber 1 is used in combination with a lens, a mirror, or the like, the number of the periodic structures 11 arranged in the x direction and the y direction is preferably adjusted to have a length equal to or longer than a diffraction limit. For example, in a case where a maximum wavelength of the electromagnetic waves incident on the electromagnetic wave absorber 1 is denoted by $\lambda max$, it is preferable that a length of one side of the electromagnetic wave absorber 1 is $3\lambda max$ or longer.

In FIGS. 1A and 1B, an example is shown in which the length of one period in the x direction and the y direction is the same, but different periods may be set in the x direction and the y direction as long as Expression 2 is satisfied.

A height h from the bottom surface portion B (xy plane) of the periodic structure 11 to the top is expressed by Expression 4.

$$h \geq (\lambda max/4) \qquad ... \text{(Expression 4)}$$

More preferably, the height h is expressed by Expression 5:

$$(\lambda max/2) < h \leq \lambda max \qquad ... \text{(Expression 5)}.$$

For example, in a case where the maximum wavelength of the electromagnetic waves is 3 mm (lowest frequency of 100 GHz), the height h of the periodic structure 11 is preferably 1.5 mm or longer and 3.0 mm or shorter. It is preferable that the heights of the plurality of periodic structures 11 constituting the electromagnetic wave absorber 1 are uniform, but the heights may be different from each other as long as they are within the ranges of Expressions 4 and 5. By setting the height in this manner, the electromagnetic wave absorber 1 can achieve a high absorption rate.

As shown in FIG. 1B, a thickness d of the periodic structure 11 is preferably selected from a range of $(\lambda min/15)$ or more and $\lambda min$ or less, but may be smaller than $(\lambda min/15)$. For example, in a case where $\lambda min = 300$ $\mu$m (maximum frequency of 1 THz), the thickness d of the periodic structure 11 is preferably selected from a range of 20 $\mu$m or more and 300 $\mu$m or less, but may be smaller than 20 $\mu$m. It is preferable that the thickness d is uniform in the entire structure, but the thickness d may be different from each other as long as it is within the above range. In addition, as shown in FIG. 1B, a predetermined thickness t is provided for the bottom surface portion B of the square pyramid-shaped periodic structure 11, and t is preferably 200 $\mu$m or more. With such a shape, the physical strength against bending can be improved.

In the example shown in FIGS. 1A and 1B, the periodic structure 11 has a square pyramid shape, but may have a triangular pyramid shape, a pentagonal pyramid shape, a hexagonal pyramid shape, or a conical shape. A shape of the space 112 provided in the periodic structure 11 may be the same as a shape of the square pyramid that is an appearance structure of the periodic structure 11, but may be another shape. A combination of an appearance shape of the periodic structure 11 and a shape of the space 112 inside the periodic structure 11 may be different shapes.

In the example shown in FIG. 1B, a cross-sectional shape of the periodic structure 11 may be a structure that linearly inclines from the bottom surface portion B to the top, but may be another shape. For example, the cross-sectional shape may be a projectile shape that is inclined quadratically or a Fuji mountain shape that is inclined exponentially.

In the example shown in FIG. 1B, a tip shape of the periodic structure 11 is a sharp shape, but may be another shape. For example, the tip shape may be a spherical shape or a flat shape. When the spherical shape is used and a minimum wavelength of a band of the electromagnetic waves to be targeted is denoted by $\lambda min$, a diameter of the tip is preferably formed within $10/\lambda min$. In addition, the top may be flat, and in this case, a length of one side is preferably formed within $10/\lambda min$. With such a configuration, the physical durability can be improved while reducing the reflectivity of the electromagnetic wave absorber.

With regard to the area $\Delta S_1$ of an opening 111 provided in a side surface of the periodic structure 11, it is preferable, from the viewpoint of heat capacity, to increase the areal fraction (area occupancy ratio) of the opening on the side surface. However, from the viewpoint of the absorption rate, an area occupancy ratio of the total area of the opening 111 in the entire area of the side surface of one periodic structure 11 (in the case of FIG. 1B, $4 \times \Delta S_1$) is preferably 0% or more and 30% or less.

In the example shown in FIG. 1B, the shape of the opening 111 is a triangle, but may be another shape. The shape of the opening 111 may be, for example, a polygon such as a quadrangle or a pentagon, or a circle or an ellipse. The shapes of the openings 111 included in the plurality of periodic structures 11 may be different from each other.

In the side surface of the periodic structure 11, a position where the opening 111 is provided is preferably from the top of the periodic structure 11 to a vicinity of the center portion of the side surface. The reason for this is that a high absorption rate can be achieved while reducing the heat capacity. However, the position of the opening 111 is not limited to the above example.

By having such a shape, the periodic structure 11 has a cross-sectional area parallel to the bottom surface portion B (xy plane) that continuously decreases from the bottom surface portion B to the top. As a result, it is found that the periodic structure 11 having such a shape behaves like a multi-layer film in which an equivalent complex refractive index changes according to the cross-sectional area parallel to the bottom surface in terms of the absorption of the electromagnetic waves. Therefore, with such a periodic structure 11, the reflection loss due to the periodic structure 11 can be reduced, so that the electromagnetic wave absorber 1 having a very high absorption rate of the electromagnetic waves can be obtained.

The periodic structure 11 described above is not particularly limited as long as it is a material that does not reflect the electromagnetic waves to be targeted with a high reflectivity, and is formed of, for example, a material satisfying Expression 6:

$$(1/\rho)/(2\pi\varepsilon f) \leq 100 \qquad ... \text{(Expression 6)}$$

The character "$\rho$" is a volume resistivity of the material, $\varepsilon$ is a dielectric constant of the material, and f is a frequency of the electromagnetic waves.

Examples of such a material include amorphous thermoplastic resins such as a polymethyl methacrylate resin, a polycarbonate resin, a polystyrene resin, a cycloolefin polymer resin, a crosslinked polyethylene resin, a polyvinyl chloride resin, a polyarylate resin, a polyphenylene ether resin, a modified polyphenylene ether resin, a polyetherimide resin, a polyethersulfone resin, a polysulfone resin, and a polyetherketone resin; crystalline thermoplastic resins such as a polyethylene terephthalate resin, a polyethylene naphthalate resin, a polyethylene resin, a polypropylene resin, a polybutylene terephthalate resin, an aromatic polyester resin, a polyacetal resin, and a polyamide resin; ultraviolet-curable resins and thermosetting resins such as an acrylic resin, an epoxy resin, a urethane resin, a phenolic resin, a urea resin, a melamine resin, and an unsaturated polyester resin; organic substrates such as a triacetate resin; and inorganic materials such as alumina, zirconia, aluminum nitride, silicon carbide, silicon nitride, forsterite, cordierite, sialon, machinable ceramics, barium titanate, lead zirconate titanate, ferrite, mullite, silicon, diamond, sapphire, and glass. In addition, a composite material within the range of effective physical properties, such as a high thermal conductivity resin containing an inorganic mineral, an antistatic resin containing carbon, alumina, metal particles, or metal fibers, may be used. From the viewpoint of productivity, a monolayer is preferable, but a multilayer may be used in order to impart functionality such as improvement of environmental resistance and improvement of mechanical strength, and a part of the structure may be composed of different materials.

The heat conductive layer 12 is a film formed on a surface of the periodic structure 11. Here, the surface of the periodic structure 11 means the outer surface of the periodic structure 11, that is, the side surface excluding the opening 111 of the pyramidal structure, and the inner surface of the periodic structure 11, that is, the surface constituting the space 112 provided in the periodic structure 11. The heat conductive layer 12 is disposed to be connected to a thermal detection section (not shown in FIGS. 1A and 1B). The thermal detection section is an external configuration for detecting the intensity of the electromagnetic waves absorbed by the electromagnetic wave absorber 1 by detecting the thermal energy in a case where the energy of the incident wave is converted into the thermal energy by the electromagnetic wave absorber 1.

The heat conductive layer 12 is continuously formed on the outer surface and the inner surface of the periodic structure 11. In the present specification, the heat conductive layer 12 continuously formed means that heat applied to a part of the heat conductive layer 12 formed on the surface of the periodic structure 11 can be conducted to the entire heat conductive layer 12. With such a heat conductive layer 12, the electromagnetic waves incident from the top side of the periodic structure 11 can be absorbed and converted into thermal energy by the periodic structure 11, and the thermal energy can be quickly transmitted to the thermal detection section by the heat conductive layer 12. As a result, the electromagnetic wave absorber 1 having high thermal responsiveness can be obtained.

The heat conductive layer 12 is composed of, for example, a metal. The thermal conductivity of the heat conductive layer is preferably greater by one order of magnitude or more than that of the base material constituting the periodic structure 11, and more preferably greater by two orders of magnitude or more. For example, in a case where the periodic structure 11 is composed of a resin, since a typical thermal conductivity of the resin is about 0.1 W/mK, the thermal conductivity of the heat conductive layer 12 is preferably 1 W/mK or more, and more preferably 10 W/mK or more.

The material of the heat conductive layer 12 can be selected from, for example, metal materials such as aluminum, nickel, chromium, platinum, palladium, titanium, tungsten, iron, zinc, magnesium, tin, gold, silver, and copper; alloy materials such as nichrome, indium-tin oxide, nickel-phosphorus, and nickel-boron; ceramics such as alumina and silicon carbide; nitrides such as aluminum nitride; oxides such as silicon carbide and silicon dioxide; carbon-based materials such as diamond; and silicon. A thickness of the heat conductive layer 12 is preferably 100 $\mu$m or less, more preferably 10 $\mu$m or less, and still more preferably 1 $\mu$m or less.

In addition, in order to use the heat conductive layer 12 as a high thermal conductivity layer and an absorption layer having a high absorption rate, the heat conductive layer 12 formed on the outer surface of the periodic structure 11 is preferably composed of a metal material satisfying Expression 7. $(1/\rho)/(2\pi\varepsilon f) > 100$ ... (Expression 7)

In order to satisfy Expression 7, for example, it is necessary to select a metal such as aluminum, nickel, chromium, platinum, palladium, titanium, tungsten, iron, zinc, magnesium, tin, gold, silver, and copper, or an alloy such as nichrome, indium tin oxide, nickel-phosphorus, and nickel-boron as the material of the heat conductive layer 12, and further to make the film thickness thinner than an electromagnetic shielding length $\delta$ expressed by Expression 8:

$$\delta = \frac{\sqrt{\rho}}{\sqrt{\pi\mu f}} \quad \text{... (Expression 8).}$$

The character "$\mu$" here denotes a magnetic permeability of the material.

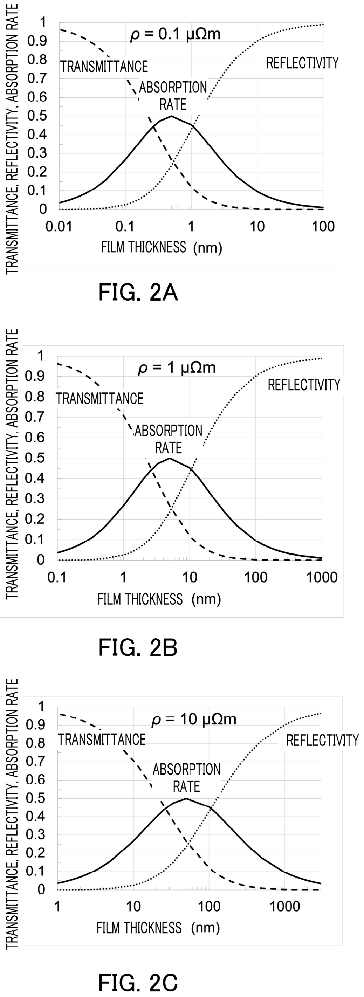

A film thickness at which the maximum absorption rate is achieved in the thin metal film having an electromagnetic shielding length or less changes depending on the volume resistivity. FIGS. 2A to 2C are graphs showing a film thickness dependence of a transmittance, a reflectivity, and an absorption rate in a case where electromagnetic waves are perpendicularly incident on a thin metal film having a length equal to or less than an electromagnetic shielding length. FIGS. 2A to 2C are graphs created by calculation with reference to Non-Patent Literature 1 [L. N. Hadley, D. M. Dennison, J. Opt. Soc. Am. 1947, 37, 451].

FIG. 2A shows a case of $\rho = 0.1$ $\mu\Omega$m, FIG. 2B shows a case of $\rho = 1$ $\mu\Omega$m, and FIG. 2C shows a case of $\rho = 10$ $\mu\Omega$m. FIGS. 2A to 2C show that the absorption rate is maximized at a film thickness at which the reflectivity and the transmittance match each other according to the energy conservation law, and the maximum value is 50%.

Examples of the metal material having $\rho = 0.1$ $\mu\Omega$m include pure metal materials such as aluminum, chromium, and nickel. In a case where these materials are used as the heat conductive layer 12, the absorption rate can be maximized by setting the film thickness to 0.5 nm $\pm$ 0.35 nm.

In addition, examples of the metal material having $\rho = 1$ $\mu\Omega$m include alloys such as nichrome and indium tin oxide. In a case where these materials are used as the heat conductive layer 12, the film thickness may be set to a range of 5 nm $\pm$ 3.5 nm in order to maximize the absorption rate.

In addition, examples of the metal material having $\rho = 10$ $\mu\Omega$m or more include alloys such as Ni-P (Ni content of 91% or more and 93% or less, P content of 7% or more and 9% or less). In a case where the material having $\rho = 10$ $\mu\Omega$m is used as the heat conductive layer 12, the film thickness may be set to a range of 50 nm $\pm$ 35 nm in order to maximize the absorption rate.

As shown in FIG. 2B, the maximum absorption rate can be realized with a film thickness in the range of 5 nm $\pm$ 3.5 nm, but when the film thickness deviates by 3.5 nm from 5 nm, the reflectivity and the transmittance vary by about 20% in total. Therefore, from the viewpoint of expanding the allowable range of the film thickness at which the optimum optical characteristics are obtained, it is more desirable to use a material having $\rho$ larger than $\rho = 1$ $\mu\Omega$m shown in FIGS. 2A to 2C as the heat conductive layer 12. Specifically, as shown in FIG. 2C, a substance having $\rho = 10$ $\mu\Omega$m or more is preferable, and for example, in a case where a Ni-P plating film is used as the heat conductive layer 12, since the volume resistivity of the Ni-P plating film is $\rho = 30$ $\mu\Omega$m, the film thickness at which the favorable optical characteristics are obtained can be selected from a range of 90 nm or more and 180 nm or less. As described above, by using the alloy material having $\rho$ larger than 10 $\mu\Omega$m as the heat conductive layer 12, the selection range of the film thickness is increased, so that the heat conductive layer 12 having favorable optical characteristics can be more easily formed.

It is preferable that the heat conductive layer 12 is uniformly formed on the entire surface of the periodic structure 11, but may be partially formed on the surface of the periodic structure 11 as long as it is continuously formed. In addition, the film thickness may not be uniform as long as it is within the above range.

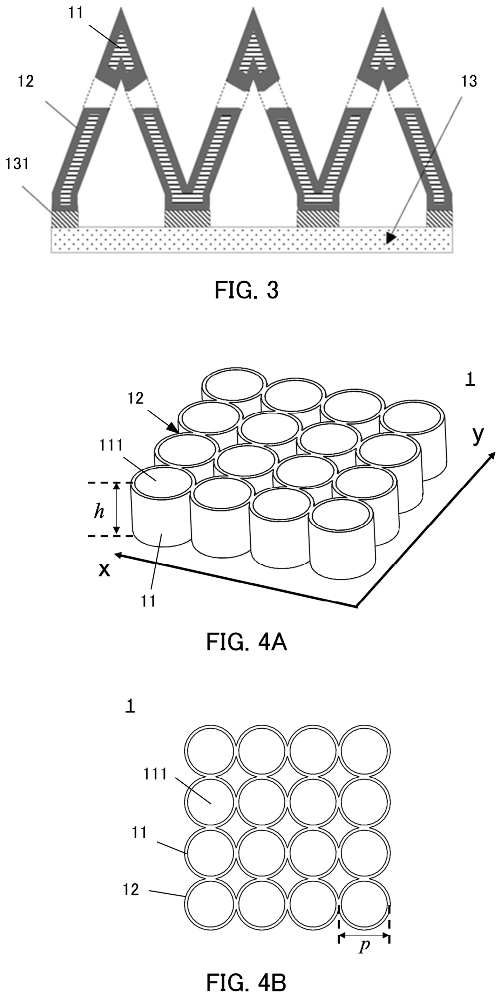

In a case where the electromagnetic wave absorber 1 is used for a purpose other than the power meter, a metal plate 13 may be further provided as shown in FIG. 3. FIG. 3 is a cross-sectional view showing an example in which the metal plate 13 is provided on the bottom surface side of the electromagnetic wave absorber 1. The metal plate 13 is provided to be in contact with the heat conductive layer 12 formed on the surface of the bottom surface portion B of the periodic structure 11.

The metal plate 13 can reflect a component of the electromagnetic waves incident from a direction facing the xy plane of the periodic structure 11 that is not completely absorbed by the periodic structure 11 and the heat conductive layer 12. As a result, the reflected component can be reabsorbed by the periodic structure 11 and the heat conductive layer 12, and the absorption rate of the electromagnetic wave absorber 1 can be maximized.

It is preferable that the metal plate 13 reflects 100% of the electromagnetic waves. Therefore, it is preferable that the metal plate 13 is composed of a material having a thickness of Expression 8 or more. Examples of the material of the metal plate 13 include aluminum, nickel, chromium, platinum, palladium, titanium, tungsten, iron, zinc, magnesium, tin, gold, silver, and copper. For example, in a case where copper having a lowest frequency to be targeted of 100 GHz and a volume resistivity $\rho = 0.02\ \mu\Omega m$ is used as the metal plate 13, the thickness thereof is preferably 210 nm or more according to Expression 8, and for example, the metal plate 13 may be a copper foil having a thickness of 20 $\mu$m. However, the thickness of the metal plate 13 is not particularly limited.

An adhesive layer 131 between the periodic structure 11 and the heat conductive layer 12 and the metal plate 13 may be appropriately selected from an epoxy-based adhesive, a heat radiation adhesive, a thermal conductive grease, a conductive adhesive, solder, and the like.

<Second Exemplary Configuration>

Next, a second exemplary configuration of the electromagnetic wave absorber 1 according to the present disclosure will be described. FIGS. 4A and 4B are diagrams for describing a second exemplary configuration of the electromagnetic wave absorber 1 according to the present disclosure.

In the second exemplary configuration, the electromagnetic wave absorber 1 also includes the periodic structure 11 and the heat conductive layer 12. FIG. 4A is a perspective view of the electromagnetic wave absorber 1 of the second exemplary configuration. In the second exemplary configuration, as shown in FIG. 4A, the periodic structure 11 is a columnar structure that is aligned in a direction perpendicular to the xy plane and that has the opening 111 provided in a bottom surface (upper bottom surface) facing the xy plane, and the columnar structures are arranged periodically along the xy plane. FIG. 4B is a top view of the electromagnetic wave absorber 1 of the second exemplary configuration.

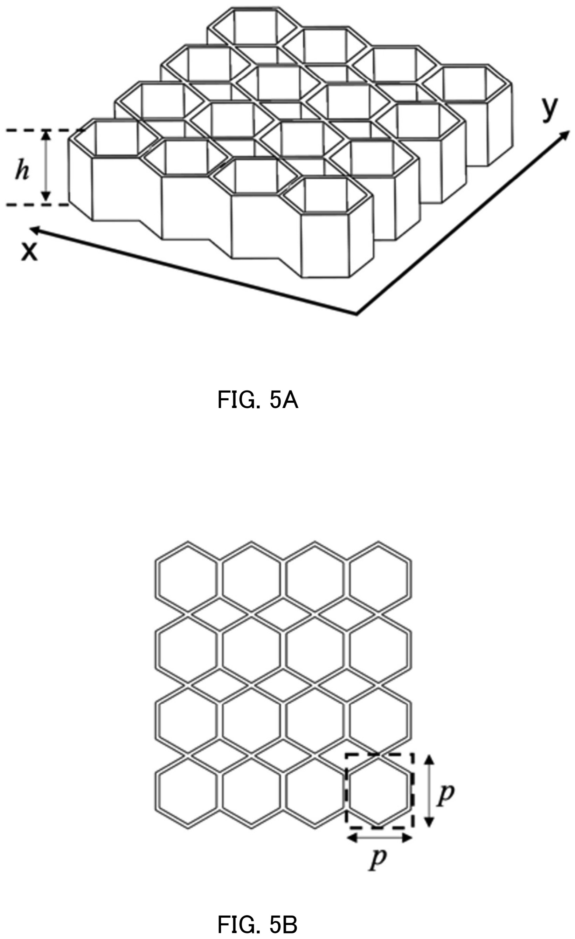

In FIG. 4A, the periodic structure 11 has a cylindrical shape, but the present disclosure is not limited to this, and for example, the periodic structure 11 may have a prism shape. FIG. 5A and FIG. 5B are diagrams showing an example in a case where the periodic structure 11 has a hexagonal prism shape. FIG. 5A and FIG. 5B are a perspective view and a top view of the electromagnetic wave absorber 1 in a case where the periodic structure 11 has a hexagonal prism shape, respectively.

The period p at which the periodic structure 11 is provided may be expressed by Expression 1 or 2, or more preferably Expression 3, as in the first exemplary configuration.

$$p \leq \lambda min \qquad \text{... (Expression 1)}$$

$$(\lambda min/4) \leq p \leq \lambda min \qquad \text{... (Expression 2)}$$

$$p = (\lambda min/4) \qquad \text{... (Expression 3)}$$

In addition, the height h from the bottom surface portion B (xy plane) of the periodic structure 11 to the top is set to a height satisfying Expression 4 as in the first exemplary configuration, so that the electromagnetic wave absorber 1 can achieve a high absorption rate. However, in the second exemplary configuration, since the cross-sectional area parallel to the bottom surface does not change with the height, it is preferable to increase the height as shown in Expression 5 in order to achieve a higher absorption rate:

$$h \geq (\lambda max/4) \qquad \text{... (Expression 4)}$$

$$(\lambda max) < h \leq 2\lambda max \qquad \text{... (Expression 5)}$$

The heat conductive layer 12 is continuously formed on an edge portion of an upper surface of the cylindrical periodic structure 11 and side surfaces (outer surfaces and inner surfaces). As a result, the electromagnetic wave absorber 1 of the second exemplary configuration can suitably absorb the electromagnetic waves as in the first exemplary configuration.

<Third Exemplary Configuration>

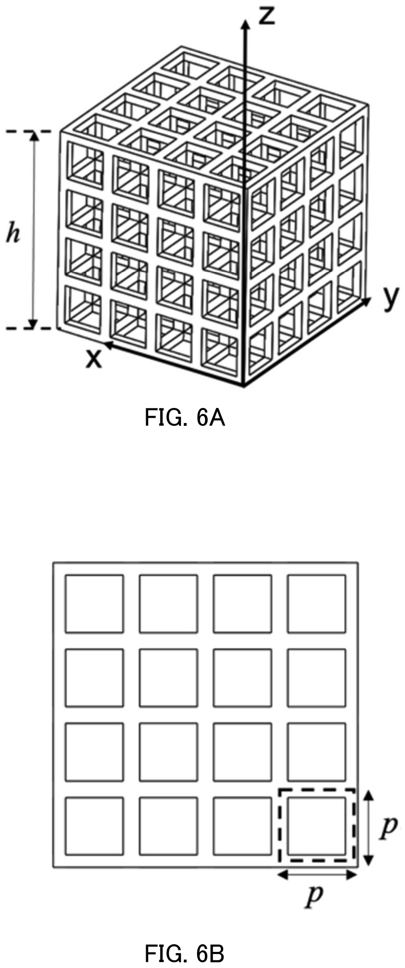

Next, a third exemplary configuration of the electromagnetic wave absorber 1 according to the present disclosure will be described. FIGS. 6A and 6B are diagrams for describing a third exemplary configuration of the electromagnetic wave absorber 1 according to the present disclosure. FIG. 6A is a perspective view of the electromagnetic wave absorber 1 of the third exemplary configuration. FIG. 6B is a top view of the electromagnetic wave absorber 1 of the third exemplary configuration.

In the third exemplary configuration, the electromagnetic wave absorber 1 also includes the periodic structure 11 and the heat conductive layer 12. The third exemplary configuration shows an example in which a lattice structure that extends not only in a direction along the xy plane but also in a height direction is provided as the periodic structure 11.

The period p and the height h of the periodic structure 11 may be set as in the first exemplary configuration and the second exemplary configuration.

The heat conductive layer 12 is continuously formed on an entire surface of a lattice frame of the periodic structure 11. As a result, the electromagnetic wave absorber 1 of the third exemplary configuration can suitably absorb the electromagnetic waves as in the first exemplary configuration and the second exemplary configuration.

<Fourth Exemplary Configuration>

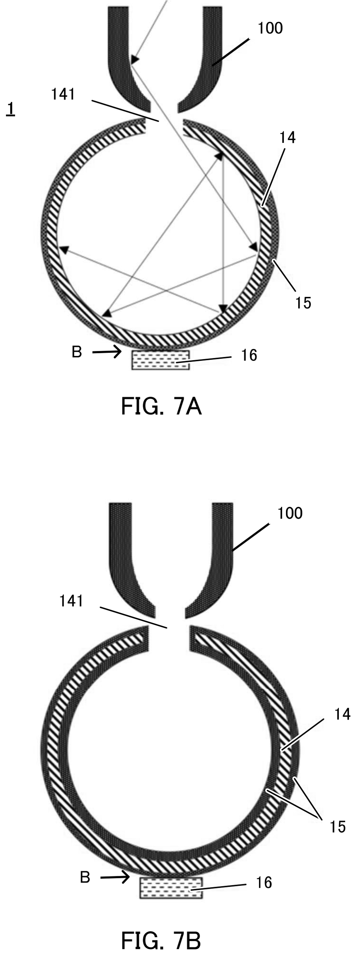

Next, a fourth exemplary configuration of the electromagnetic wave absorber 1 according to the present disclosure will be described. FIGS. 7A and 7B are cross-sectional views for describing a fourth exemplary configuration of the electromagnetic wave absorber 1 according to the present disclosure.

The electromagnetic wave absorber 1 of the fourth exemplary configuration includes a hollow structure 14 having a spherical shape or a cylindrical shape and having a circular cross section, a first heat conductive layer 15 formed on a surface of the hollow structure 14, and a second heat conductive layer 16 that is disposed on the bottom surface portion B of the hollow structure 14 and that is continuously formed with the first heat conductive layer 15. The hollow structure 14 is, for example, an integrating sphere.

An opening 141 is provided in the hollow structure 14 at a position facing the bottom surface portion B. The electromagnetic waves incident on the electromagnetic wave absorber 1 are collected by a light collector 100 and are incident into the hollow structure 14 from the opening 141. As the light collector 100, a Winston cone, a parabolic mirror, or the like may be used.

FIG. 7A shows an example in which the first heat conductive layer 15 is formed only on the outer surface of the hollow structure 14. In addition, in FIG. 7A, an optical path of the electromagnetic waves incident from the light collector 100 is indicated by a solid line arrow.

As indicated by an arrow in FIG. 7A, the electromagnetic waves collected by the light collector 100 and incident into the hollow structure 14 are partially absorbed by the hollow structure 14, and the remainder is reflected by the surface (inner surface) of the hollow structure 14. As a result, since all the incident electromagnetic waves are reflected inside the hollow structure 14 until all the electromagnetic waves are absorbed, the electromagnetic wave absorber 1 having a very high absorption rate of the electromagnetic waves can be obtained.

The electromagnetic waves absorbed by the hollow structure 14 are converted into thermal energy and are transmitted to the first heat conductive layer 15, and are further transmitted to the second heat conductive layer 16 via the first heat conductive layer 15. The second heat conductive layer 16 is connected to a thermal detection section (not shown). As a result, the electromagnetic wave absorber 1 having high thermal responsiveness can be obtained.

As shown in FIG. 7B, the hollow structure 14 may be used only as a mere frame, and the front surface of the hollow structure 14 may be covered with the first heat conductive layer 15. Even in this case, as in the example shown in FIG. 7A, the electromagnetic wave absorber 1 having a very high absorption rate and high thermal responsiveness can be obtained.

<Effects>

The action and effect of the electromagnetic wave absorber according to the above-described exemplary configurations will be described below. As described above, the electromagnetic wave absorber 1 according to the present disclosure is characterized in that a heat conductive layer (heat conductive layer 12 or first heat conductive layer 15 and second heat conductive layer 16) is continuously formed on a surface (outer surface and inner surface) of a hollow structure (periodic structure 11 or hollow structure 14).

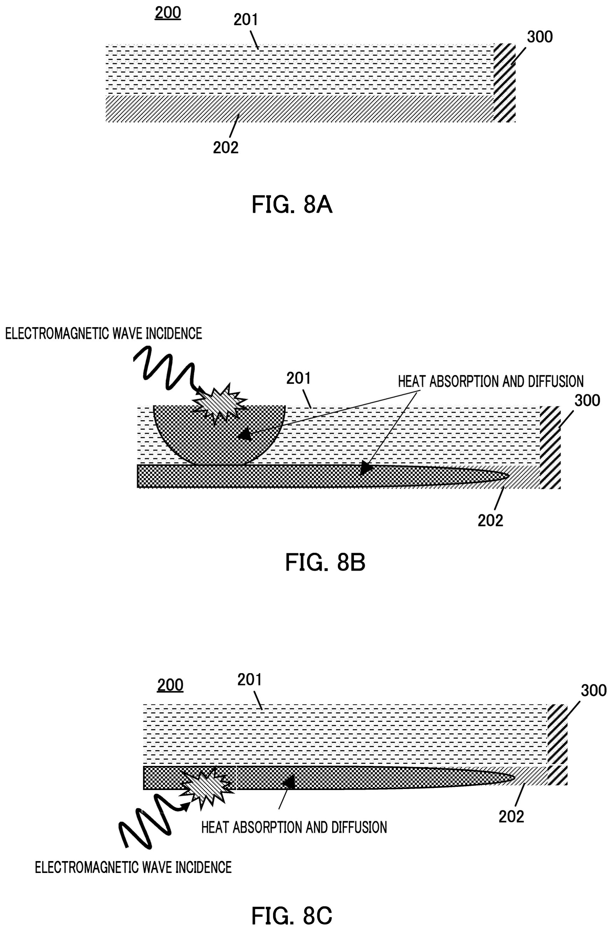

FIGS. 8A to 8C are conceptual diagrams for describing a mechanism in which the thermal responsiveness is improved by a heat conductive layer continuously formed on a surface of a structure. FIG. 8A shows a structure 200 in which a heat conductive layer 202 is formed on a surface of a resin layer 201. A thermal detection section 300 as an external configuration is provided at end parts of the resin layer 201 and the heat conductive layer 202. Here, it is assumed that the heat conductive layer 202 is a thin film having a higher thermal conductivity and a smaller heat capacity (= specific gravity × specific heat × volume) than the resin layer 201. A difference in thermal conductivity between the resin layer 201 and the heat conductive layer 202 is preferably 10 times or more and more preferably 100 times or more.

In a case where the structure 200 is locally irradiated with electromagnetic waves from the resin layer 201 side, a diffusion path of the thermal energy is as shown in FIG. 8B. First, the thermal energy generated on the surface of the resin layer 201 irradiated with the electromagnetic waves is isotropically diffused from the thickness direction to the in-plane direction and is transmitted to the heat conductive layer 202. In this case, since the heat capacity of the heat conductive layer 202 is smaller than that of the resin layer 201, a relatively large local temperature rise occurs even with a relatively small amount of thermal energy.

According to Fourier's law, the thermal energy is transmitted in a direction in which a temperature gradient is generated, and the magnitude of the transmitted thermal energy is proportional to the thermal conductivity of the substance. Therefore, the thermal energy generated in the heat conductive layer 202 flows in the heat conductive layer 202 having a higher thermal conductivity rather than the resin layer 201. As a result, the entire heat conductive layer 202 is heated faster than the entire structure 200 is heated, so that the thermal energy generated by the absorption of the electromagnetic waves in the structure 200 is quickly detected by the thermal detection section 300 via the heat conductive layer 202.

As described above, by providing the heat conductive layer 202 having a high thermal conductivity on the surface of the resin layer 201, the structure 200 having high thermal responsiveness can be obtained.

As shown in FIG. 8C, in a case where the electromagnetic waves are irradiated from the heat conductive layer 202 side, the thermal energy generated by the absorption of the electromagnetic waves by the heat conductive layer 202 is quickly diffused in the heat conductive layer 202 having a high thermal conductivity. Therefore, the thermal detection by the thermal detection section 300 is realized at a higher speed than the thermal diffusion process illustrated in FIG. 8B, since the thermal energy is not transmitted through the resin layer 201.

In any of the first to fourth exemplary configurations of the electromagnetic wave absorber 1 described above, the thermal energy generated by absorbing the incident electromagnetic waves can be quickly transmitted to the thermal detection section by the heat conductive layer continuously formed on the surface of the hollow structure. As a result, the electromagnetic wave absorber 1 having high thermal responsiveness can be obtained.

In addition, in the electromagnetic wave absorber 1 of the first exemplary configuration, the periodic structure 11 having a pyramidal shape is formed as the hollow structure. As described above, it is known that a structure in which the cross-sectional area parallel to the bottom surface changes from the top to the bottom surface portion behaves like a multi-layer film in which an equivalent complex refractive index linearly changes according to the change in the cross-sectional area in terms of the reflectivity in a case where a height of the pyramidal shape is set to a size of a wavelength of the electromagnetic waves and an arrangement period of the periodic structures 11 is set to be smaller than the wavelength of the electromagnetic waves. As a result, a low reflectivity can be achieved, and as a result, a high absorption rate can be achieved.

In addition, it is known that a structure having a three-dimensional shape in which a columnar substance group, a honeycomb structure, or a lattice structure, or a substance branched in a dendritic manner, which is aligned in a direction perpendicular to the xy plane, is periodically arranged can also achieve a low reflectivity. Therefore, in the second exemplary configuration and the third exemplary configuration, since a cylindrical structure, the hexagonal prism-shaped structure, and the lattice structure are used as the hollow structure 14, a low reflectivity can be achieved, and as a result, a high absorption rate can be achieved.

In addition, as in the fourth exemplary configuration, in a structure in which the electromagnetic waves incident from the opening are confined to the hollow structure 14 having a spherical shape or a cylindrical shape and the components that cannot be absorbed are repeatedly totally reflected, a very high absorption rate can be realized.

Therefore, in the electromagnetic wave absorber 1 according to the present disclosure, the entire electromagnetic wave absorber 1 can be heated at a high speed by the heat conductive layer continuously formed on the surface of the hollow structure. Therefore, for example, even in a case where the hollow structure is a material having poor thermal responsiveness, a high absorption rate in a wide band can be realized by the heat conductive layer, and the thermal responsiveness can also be improved. Therefore, the electromagnetic wave absorber according to the present disclosure shown in the first to fourth exemplary configurations can achieve both high thermal responsiveness and high absorption rate.

<Manufacturing Method>

A method of manufacturing the electromagnetic wave absorber 1 according to the present disclosure will be described.

The hollow structure (periodic structure 11 or hollow structure 14) constituting the electromagnetic wave absorber may be formed by, for example, a 3D printer using a stereolithography (SLA) method. A thin metal film layer may be continuously formed on the surface (outer surface and inner surface) of the hollow structure formed as described above, for example, by an electroless plating method.

It is preferable to use a high-accuracy and high-speed formable optical forming method as a forming method of the 3D printer, but the present disclosure is not limited to the optical forming method, and a forming method known as a known method can be selected. Examples of the forming method other than the optical forming method include a fused deposition modeling/fused filament fabrication method (FDM/FFF method), a powder sintering method (selective laser sintering (SLS) method), and a material jetting method (ink jet type).

In addition, as a method of forming the thin metal film, a known technology such as a vacuum film forming method can be used in addition to the electroless plating method.

As described above, the electromagnetic wave absorber 1 according to the present disclosure can be manufactured using a 3D printer and electroless plating, and can be manufactured at a low cost and easily as compared with a manufacturing method having a high manufacturing cost such as cutting processing. As a result, the present disclosure can contribute to providing a high-accuracy and high-speed electromagnetic wave power meter at a low cost.

<Examples>

Hereinafter, a result of actually manufacturing the electromagnetic wave absorber 1 of each of the above-described exemplary configurations and measuring the absorption rate, the reflectivity, and the thermal responsiveness to compare the performances will be described.

(1) Measurement of Transmittance and Reflectivity

In a case where the absorption rate of the electromagnetic waves is defined as A, the reflectivity is defined as R, and the transmittance is defined as T, the absorption rate is defined by A = 1 - R - T. The transmittance and the reflectivity were measured using a terahertz time-domain spectroscopy apparatus (TR-1000, manufactured by Otsuka Electronics Co., Ltd.).

The electromagnetic wave absorber 1 was irradiated with the terahertz pulse signal in a state of being collected by a parabolic mirror using the above-described spectroscopy apparatus. The sample table was installed at an inclination of 15 degrees, and the signal reflected by the electromagnetic wave absorber 1 was collected to a detector through a parabolic mirror (diameter: 25.4 mm, focal length: 50.8 mm).

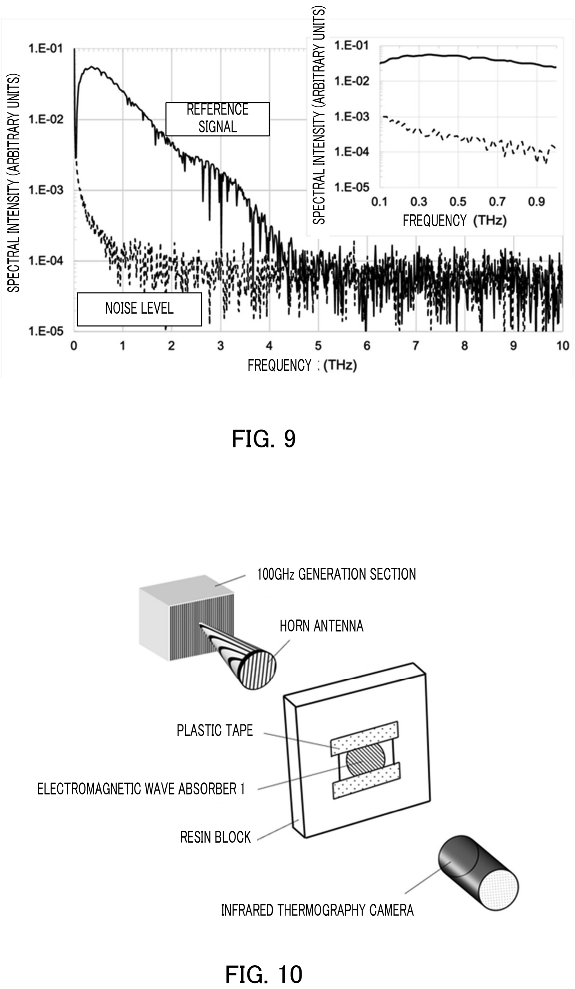

FIG. 9 is a diagram showing a spectrum and a noise level of a reflected pulse signal measured by placing a gold mirror on a placement table on which the electromagnetic wave absorber 1 is placed. An insertion view inserted in the upper right of the figure is an enlarged view in a range of 0.1 THz or more and 1.0 THz or less, and shows that an SN ratio at 0.1 THz is approximately 50.

(2) Measurement of thermal responsiveness

The thermal responsiveness characteristics were evaluated by detecting a change in the amount of infrared radiation generated in a case of temperature rise due to the absorption of the terahertz waves. FIG. 10 is a schematic diagram of a measurement system used for evaluating the thermal responsiveness.

In the present example, a signal of 16.6 GHz generated by a microwave signal generator (SynthHD Pro (v2), manufactured by Windfreak Technologies, Inc.) was input to a $6\times$ frequency multiplier (SGX-M, manufactured by Virginia Diodes, Inc.) to be frequency-converted to 100 GHz, and a conical horn antenna (WR10CH, manufactured by Virginia Diodes, Inc.) was attached to an output port of the multiplier to perform spatial radiation. In order to improve the heat insulating properties, a resin was used as a material of the jig. A plastic tape was attached to a part of the electromagnetic wave absorber 1 and attached to a resin block with a hole in the center. A diameter of an opening portion of the horn antenna was 16.3 mm.

According to Planck's black body radiation law, the wavelength of the electromagnetic waves radiated strongly by an object at a temperature near room temperature is 8 $\mu$m or more and 14 $\mu$m or less. Therefore, in the measurement system shown in FIG. 10, the infrared radiation was detected by an infrared thermography camera (Thermo FLEX F50B-ONL, manufactured by Nippon Avionics Co., Ltd.) having sensitivity in the wavelength range.

[Reference Example 1: Optical characteristics of resin plate/Ni-P plating film]

Table 1 shows the optical characteristics of the resin plate/Ni-P plating film as Reference Example 1.

Table 1

| Film thickness of heat conductive layer | Average transmittance | Average reflectance | Estimated absorption rate |
|---|---|---|---|
| 59 nm | 72% | 15% | 13% |
| 99 nm | 50% | 20% | 30% |
| 174 nm | 18% | 45% | 37% |
| 221 nm | 11% | 58% | 31% |

Table 1 shows the results of the transmittance and the reflectivity measurement in a case where a resin plate having a size of 20 mm × 20 mm × 0.95 mm was formed by optical forming and then electroless Ni-P plating was performed, and shows the absorption rate estimated from these results. Here, in the transmittance measurement, the resin plate was used as a reference signal. In addition, in the reflectivity measurement, the mirror was used as a reference signal. The values of the transmittance and the reflectivity are average values in a range of 0.1 THz or more and 1.0 THz or less. According to Table 1, it can be seen that the film thickness at which the absorption rate is maximized is approximately 100 nm or more and 180 nm or less.

[Example 1: Sample 1]

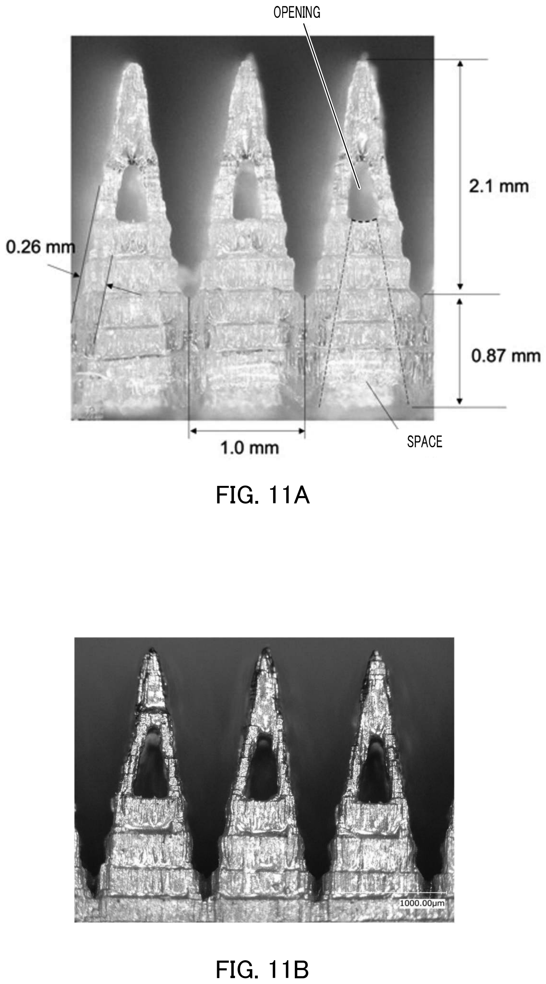

In Example 1, a sample of the electromagnetic wave absorber 1 having the shape described in the first exemplary configuration according to the present disclosure was actually manufactured, and the characteristics thereof were measured. Hereinafter, the electromagnetic wave absorber in Example 1 will be described as Sample 1. FIGS. 11A and 11B are optical microscope images of Sample 1. FIG. 11A shows a state before the heat conductive layer 12 is formed, and FIG. 11B shows a state after Ni-P plating is formed as the heat conductive layer 12.

In Sample 1, a proportion of an area occupied by the opening 111 provided in the side surface of the periodic structure 11 was 30%. In Sample 1, the periodic structures 11 were arranged in a 15 × 15 array in the x direction and the y direction of FIGS. 1A and 1B. Therefore, the effective area that interacts with the electromagnetic waves is 15 mm$^2$ × 15 mm$^2$.

In Example 1, it is assumed that Sample 1 is used for a power meter, and a metal plate as a thermal detection section is disposed on the bottom surface portion side of Sample 1. Therefore, the transmittance can be regarded as 0, and the absorption rate can be determined by measuring the reflectivity.

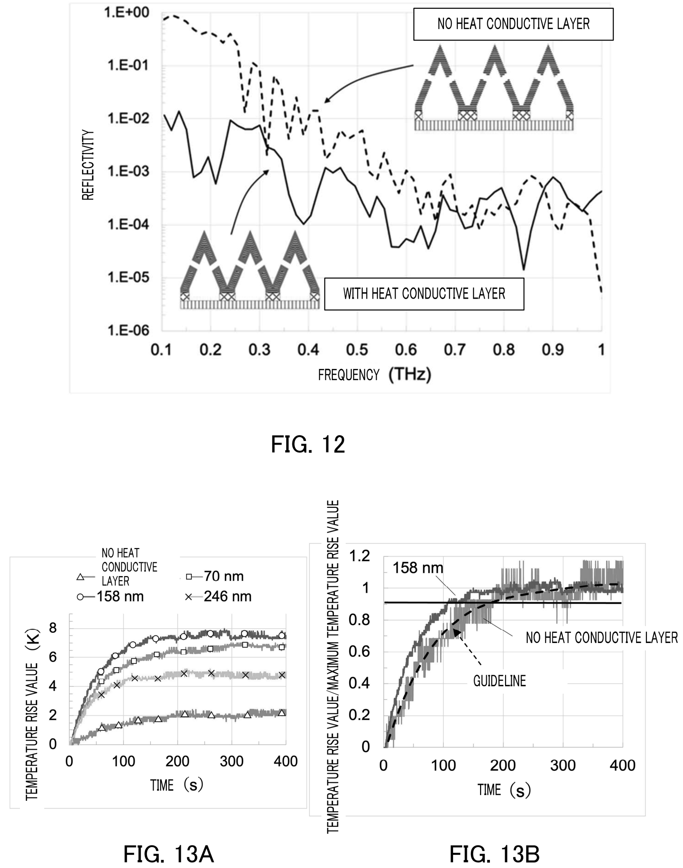

FIG. 12 is a graph showing reflection characteristics of Sample 1 before and after the heat conductive layer is formed. A film thickness of the Ni-P plating film as the heat conductive layer is 158 nm. In FIG. 12, in a range of 0.1 THz or more and 0.3 THz or less, the pulse wave incident on Sample 1 without absorption before the heat conductive layer is formed is reflected by the metal plate due to a low absorption coefficient of the hollow structure (resin layer), and as a result, the reflectivity with respect to the electromagnetic waves of more than 100 GHz is 80% or more and 90% or less. On the other hand, the reflectivity after the heat conductive layer is formed is reduced to about 1%, and it can be seen that the absorption effect of the heat conductive layer is large from the absorption rate A = 1 - R.

Table 2 is a table showing a correspondence relationship between the film thickness of the heat conductive layer and the reflectivity.

Table 2

| Film thickness of heat conductive layer | With metal backing plate | | Without metal backing plate | |
|---|---|---|---|---|
| | Transmittance | Reflectance @ 120 GHz | Transmittance | Reflectance @ 120 GHz |
| 0 | Noise level | 90% | Not measured | Not measured |
| 70 nm | Noise level | 5.8% | 32% | 2% |
| 158 nm | Noise level | 0.6% | 5% | 0.6% |
| 246 nm | Noise level | 18.6% | 0.2% | 22% |

In Table 2, the reflection characteristics with respect to the electromagnetic waves of 120 GHz are described as an example. In a case where the film thickness is thin, the reflectivity of the heat conductive layer itself is low, and the absorption rate is also low. On the other hand, in a case where the film is too thick, the reflectivity of the heat conductive layer itself is too high. The highest absorption rate is obtained at an intermediate film thickness. Such characteristics of Sample 1 are the same properties as the characteristics of the reference example (a plate-like shape in which the Ni-P film is plated). In addition, it can be seen that the suitable film thickness 158 nm of the heat conductive layer in Table 2 matches the optimal film thickness range of the heat conductive layer 12 described in the embodiment described above.

In addition, FIGS. 13A and 13B are graphs showing thermal responsiveness characteristics of Sample 1 before and after the heat conductive layer is formed. As in the evaluation of the optical characteristics, the thermal responsiveness was evaluated by disposing the metal plate as the thermal detection section on the bottom surface portion side of Sample 1. FIG. 13A shows a relationship between the film thickness of the heat conductive layer (in a case of "no heat conductive layer", 70 nm, 158 nm, and 246 nm) and the temperature rise. As shown in FIG. 13A, the maximum temperature rise value before the heat conductive layer is formed (corresponding to "no heat conductive layer" indicated by $\triangle$) is the lowest. In addition, FIG. 13B is a graph in which the vertical axis is divided by the maximum temperature rise value. For simplicity, FIG. 13B shows the value before the heat conductive layer is formed (corresponding to "no heat conductive layer") and the value after the heat conductive layer having a film thickness of 158 nm is formed. According to FIG. 13B, it can be seen that the thermal time constant is improved after the heat conductive layer is formed as compared with before the heat conductive layer is formed.

[Comparative Example 1: Magnetic loss epoxy described in Non-Patent Literature 2]

Hereinafter, the optical characteristics and the thermal responsiveness characteristics of the absorber (hereinafter, referred to as magnetic loss epoxy) obtained by processing the magnetic loss material-loaded epoxy (ECCOSORB MF-117, E&C Engineering Co., Ltd.) described in Non-Patent Literature 2 [H. Iida et al., J. Infrared Milli. Terahz. Waves 39, 5 (2018).] into a pyramidal shape and Sample 1 will be compared as Comparative Example 1.

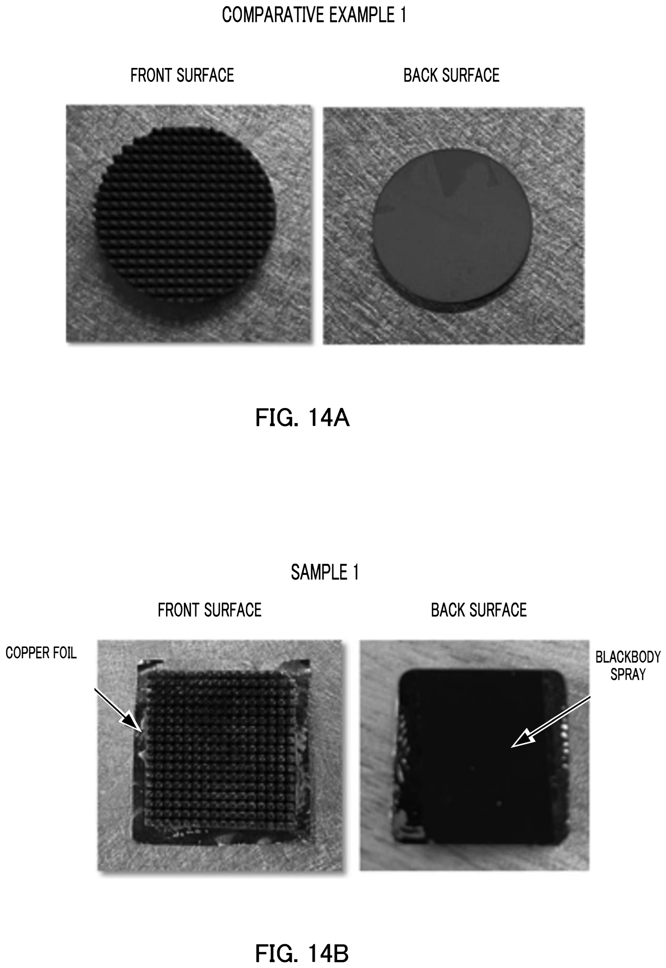

FIGS. 14A and 14B are diagrams showing photographs of Comparative Example 1 and Sample 1. FIG. 14A shows photographs of a front surface and a back surface of the magnetic loss epoxy having a circular shape with a diameter of 15 mm on which pyramid (square pyramid-shaped) structures having a height of 2 mm are arranged at an interval of a period of 0.8 mm. In addition, FIG. 14B shows a photograph of a case where a metal plate was attached to a back surface of Sample 1 and a black body spray (TA410KS, manufactured by ICHINEN TASCO CO.,) was sprayed on the back surface of the metal plate.

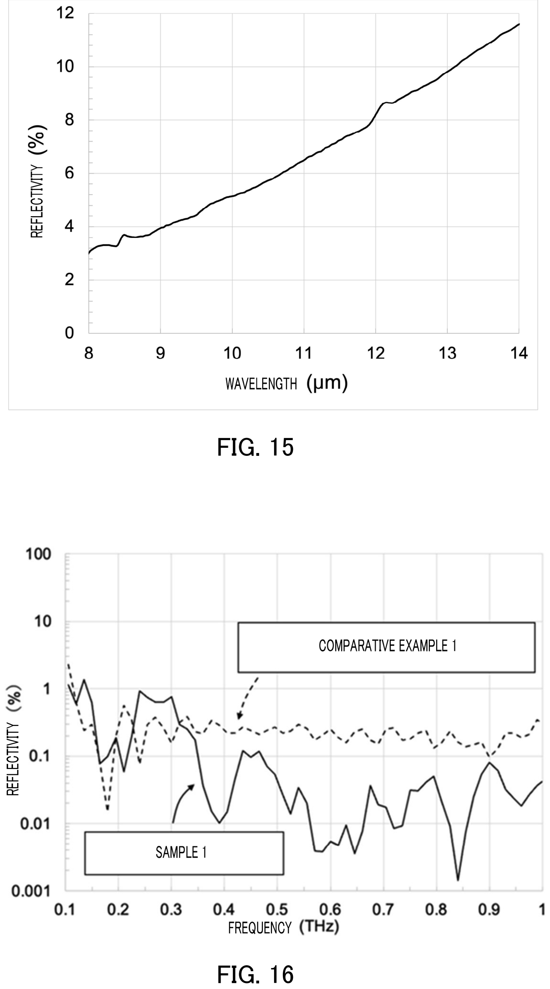

FIG. 15 is a diagram showing a measurement result of the infrared emissivity of Comparative Example 1. FIG. 15 shows a result of measuring the infrared emissivity of the magnetic loss epoxy using an infrared spectroscopy apparatus manufactured by Jasco Corporation. In FIG. 15, since the measured transmittance was equivalent to the noise level of the infrared spectroscopy apparatus, only the result of the reflectivity is shown. According to FIG. 15, it can be seen that the average emissivity in a range of 8 $\mu$m or more and 14 $\mu$m or less is about 0.94.

In order to appropriately compare Sample 1 with Comparative Example 1, the average emissivity of Sample 1 is set to 0.94 to match Comparative Example 1 by spraying the black body spray on the back surface of Sample 1.

FIG. 16 is a diagram showing a measurement result of the reflectivity obtained by time-domain spectroscopy. According to FIG. 16, it can be seen that Sample 1 according to the present disclosure can achieve a low reflectivity at the same level as the magnetic loss epoxy of Comparative Example 1. Since the transmittance component of the magnetic loss epoxy is also equivalent to the noise level, the absorption rate A = 1 - R can be determined.

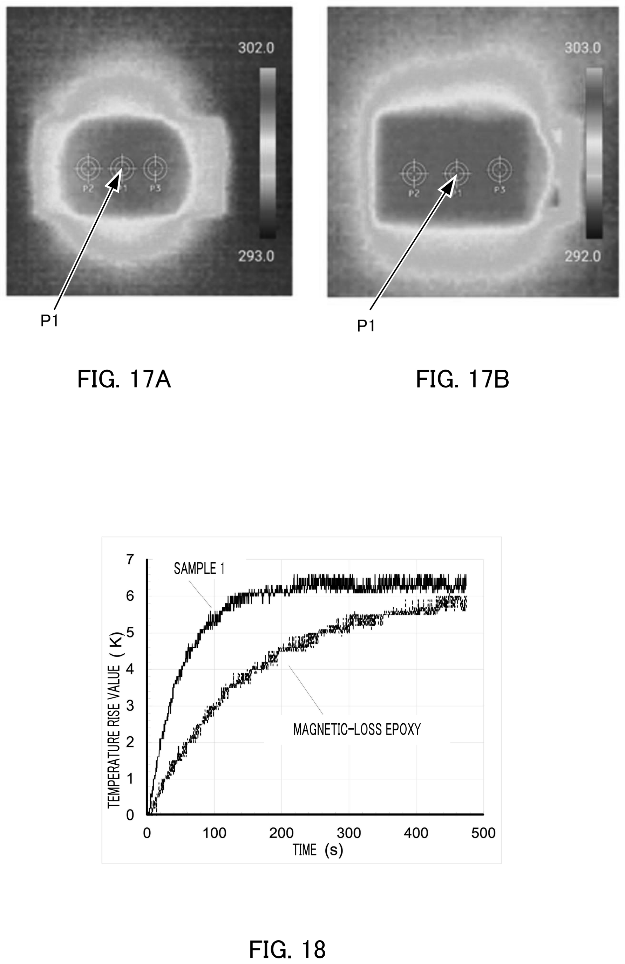

FIGS. 17A and 17B are diagrams showing a snapshot during the infrared camera measurement of Sample 1 and Comparative Example 1. FIG. 17A shows a snapshot of Sample 1, and FIG. 17B shows a snapshot of Comparative Example 1.

FIG. 18 is a diagram in which a time change in a temperature rise in a center portion (corresponding to a point P1 in FIG. 17A and FIG. 17B) of Sample 1 and Comparative Example 1 is plotted. In a case where the 90% thermal time constant is calculated based on FIG. 18, the thermal time constant of Sample 1 is 100 seconds, and the thermal time constant of the magnetic loss epoxy is 300 seconds. As a result, it can be seen that the thermal time constant of Sample 1 according to the present disclosure is improved by 3 times as compared with Comparative Example 1.

Here, the non-patent literature 2 discloses an absorber having high thermal responsiveness using isothermal control. In a case where the response time of the magnetic loss epoxy disclosed in the non-patent literature 2 is 70 seconds, the response time of Sample 1 is 23 seconds, and in a case of being used as a power meter, a very short rise time can be realized.

[Example 2: Sample 2]

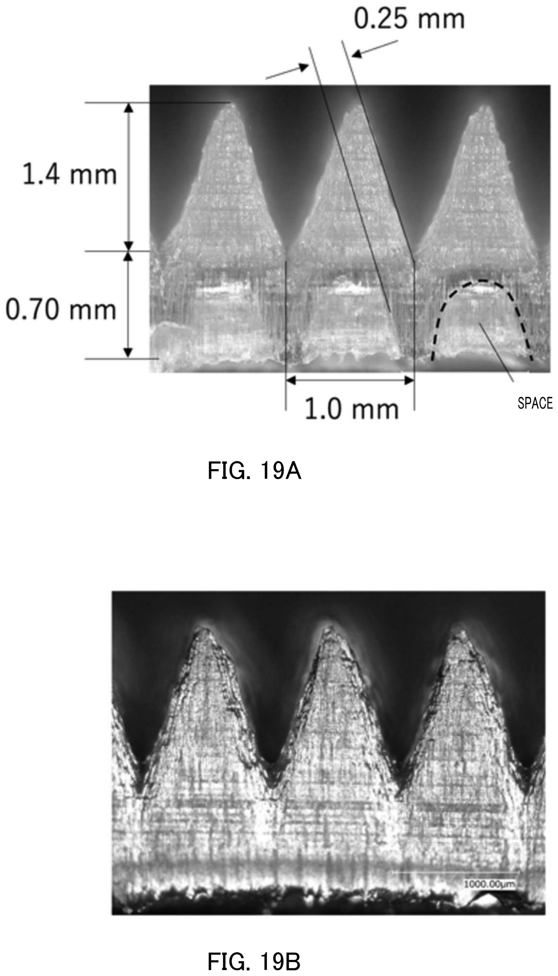

In Example 2, a sample in a case where the opening 111 is not provided in the side surface of the periodic structure 11 in the first exemplary configuration was actually manufactured, and the characteristics thereof were measured. Hereinafter, the electromagnetic wave absorber 1 in Example 2 will be described as Sample 2. FIGS. 19A and 19B are optical microscope images of Sample 2. FIG. 19A shows a state before the heat conductive layer 12 is formed, and FIG. 19B shows a state after Ni-P plating is formed as the heat conductive layer 12. The size of Sample 2 is different from that of Sample 1.

In Sample 2, as in Sample 1, the periodic structures 11 are arranged in a 15 × 15 array in the x direction and the y direction, so that the effective area that interacts with the electromagnetic waves is 15 mm$^2$ × 15 mm$^2$.

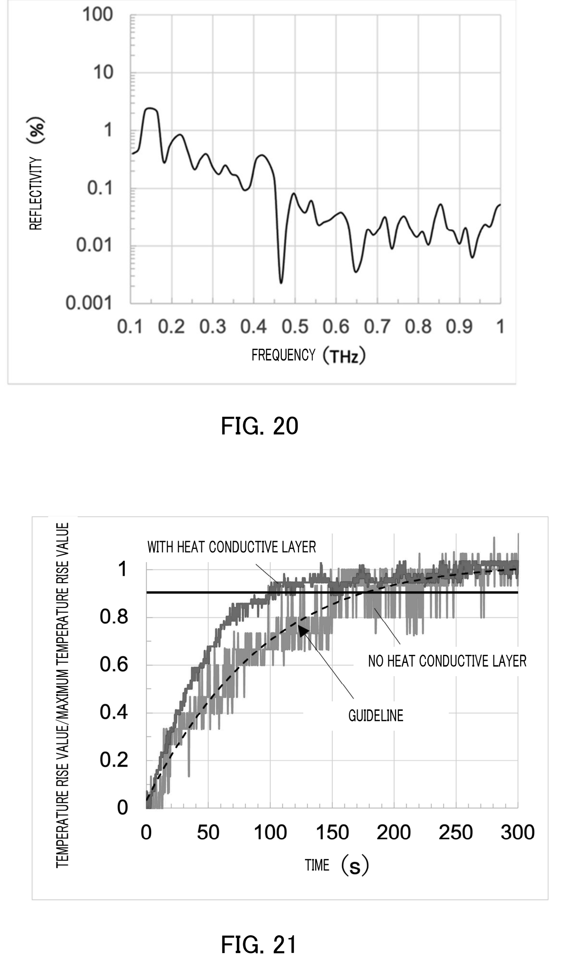

FIG. 20 is a diagram showing a frequency dependence of a reflectivity of Sample 2 after the heat conductive layer having a thickness of 132 nm is formed. As shown in FIG. 20, the maximum reflectivity was 2.4 at 120 GHz.

FIG. 21 is a diagram showing a time response in a case where a maximum temperature rise value is set to 1 for Sample 2 before and after the heat conductive layer is formed. The thickness of the heat conductive layer in FIG. 20 is 132 nm. According to FIG. 21, it can be seen that the 90% thermal time constant after the heat conductive layer is formed is 100 seconds, while the thermal time constant before the heat conductive layer is formed is 180 seconds, and the time constant is improved by forming the heat conductive layer.

[Example 3: Sample 3]

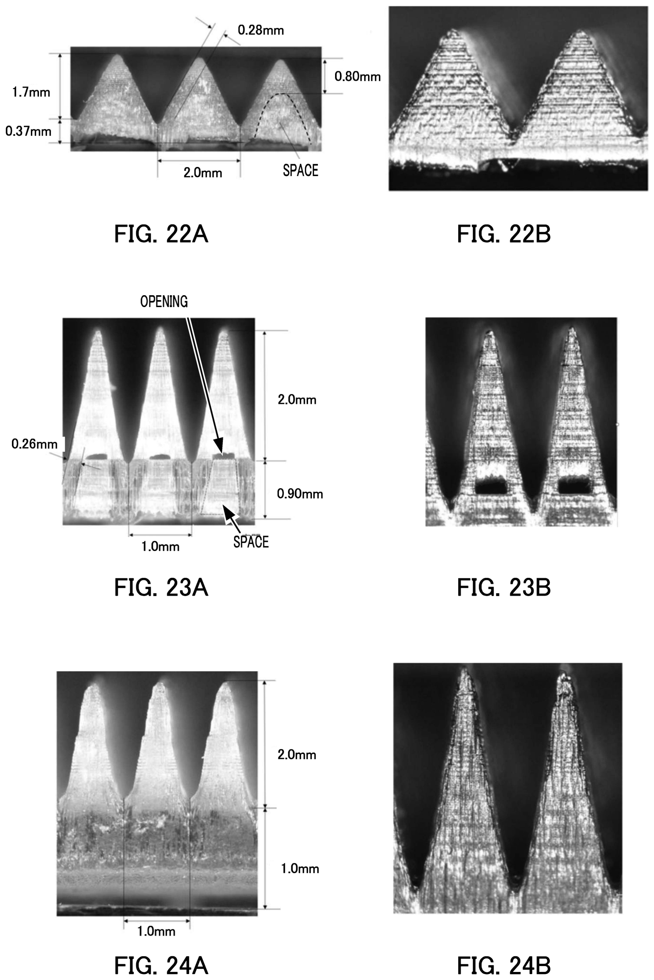

In Example 3, a sample in a case where the opening 111 is not provided in the side surface of the periodic structure 11 in the first exemplary configuration and which has a size different from that of Sample 2 was actually manufactured, and the characteristics thereof were measured. Hereinafter, the electromagnetic wave absorber 1 in Example 3 will be described as Sample 3. FIGS. 22A and 22B are optical microscope images of Sample 3. FIG. 22A shows a state before the heat conductive layer 12 is formed, and FIG. 22B shows a state after Ni-P plating is formed as the heat conductive layer 12.

In Sample 3, the periodic structures 11 are arranged in a 15 × 15 array in the x direction and the y direction. Since the size of the periodic structure 11 is different from those of Samples 1 and 2, the effective area that interacts with the electromagnetic waves is 16 mm$^2$ × 16 mm$^2$.

[Example 4: Sample 4]

In Example 4, a sample having a size different from that of Sample 1 in the first exemplary configuration was actually manufactured, and the characteristics thereof were measured. Hereinafter, the electromagnetic wave absorber 1 in Example 4 will be described as Sample 4. FIGS. 23A and 23B are optical microscope images of Sample 4. FIG. 23A shows a state before the heat conductive layer 12 is formed, and FIG. 23B shows a state after Ni-P plating is formed as the heat conductive layer 12. The size of Sample 4 is different from that of Sample 1.

In Sample 4, as in Samples 1 and 2, the periodic structures 11 are arranged in a 15 × 15 array in the x direction and the y direction, so that the effective area that interacts with the electromagnetic waves is 15 mm$^2$ × 15 mm$^2$.

[Example 5: Sample 5]

In Example 5, a sample in which the opening 111 and the space 112 are not provided in the first exemplary configuration was actually manufactured, and the characteristics thereof were measured. Hereinafter, the electromagnetic wave absorber 1 in Example 5 will be described as Sample 5. FIGS. 24A and 24B are optical microscope images of Sample 4. FIG. 24A shows a state before the heat conductive layer 12 is formed, and FIG. 24B shows a state after Ni-P plating is formed as the heat conductive layer 12. The size of Sample 5 is different from that of Sample 1.

In Sample 5, as in Sample 1, Sample 2, and Sample 4, the periodic structures 11 are arranged in a 15 × 15 array in the x direction and the y direction, so that the effective area that interacts with the electromagnetic waves is 15 mm$^2$ × 15 mm$^2$.

[Comparison between samples]

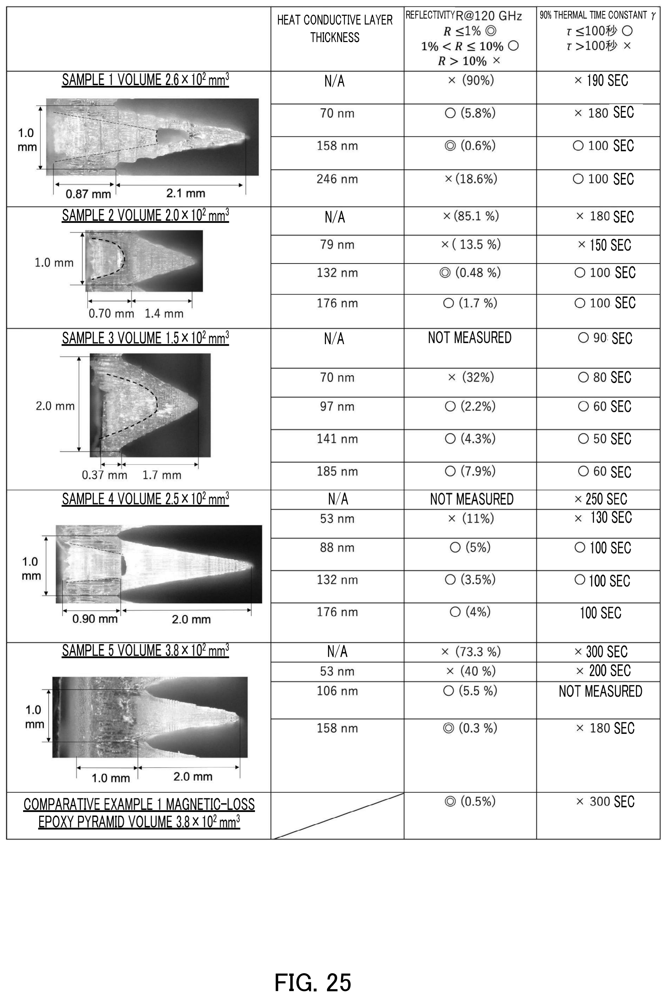

FIGS. 24A and 24B are diagrams summarizing a comparison result between the samples. As shown in FIG. 25, in Sample 1, it can be seen that the thermal time constant before the heat conductive layer is formed is 190 seconds, while the thermal time constant after the heat conductive layer is formed is as fast as 100 seconds at the maximum. This result indicates that the thermal responsiveness of the electromagnetic wave absorber 1 according to the present disclosure is improved by the heat conductive layer.

In addition, it can be seen that the thermal time constant is improved by forming the heat conductive layer in Sample 2.

In addition, it can be seen that the thermal time constant is improved by forming the heat conductive layer in Sample 3. In Sample 3, it can be seen that the thermal time constant is small because the volume is small and the heat capacity is small as compared with Sample 1 or Sample 2, but the reflectivity is slightly large because the aspect ratio of the periodic structure 11 is small.

In addition, it can be seen that the thermal time constant is improved by forming the heat conductive layer in Sample 4. In Sample 4, the position of the opening is different from that of Sample 1, so that the reflectivity is slightly increased as a result as compared with Sample 1.

In addition, it can be seen that the thermal time constant is improved by forming the heat conductive layer in Sample 5. However, in Sample 5, the volume is the largest as compared with Samples 1 to 4, so that the heat capacity is also large. Therefore, it can be seen that the thermal responsiveness is the slowest.

Although preferred embodiments of the present disclosure have been described above, the present disclosure is not limited to such specific embodiments, and at least one of various modifications or changes can be made within the scope of the invention described in the claims.

The disclosure contents of the specification, drawings, and summary of the Japanese patent application No. 2023-133366 filed on August 18, 2023 are incorporated in the present application by reference.

Industrial Applicability

The present disclosure is useful for an electromagnetic wave absorber and a method of manufacturing the same.

Reference Signs List

1 Electromagnetic wave absorber
11 Periodic structure
111 Opening
112 Space
12 Heat conductive layer
13 Metal plate
131 Adhesive layer
14 Hollow structure
141 Opening
15 First heat conductive layer
16 Second heat conductive layer
100 Light collector
200 Structure
201 Resin layer
202 Heat conductive layer
300 Thermal detection section

**Claims**

1. An electromagnetic wave absorber, comprising:

   a hollow structure having a bottom surface portion; and
   a heat conductive layer continuously formed from an outer surface of the hollow structure to the bottom surface portion.

2. The electromagnetic wave absorber according to claim 1, wherein
   the hollow structure is a periodic structure that is periodically formed along a predetermined plane.

3. The electromagnetic wave absorber according to claim 2, wherein

   a length p of one period of the periodic structure is expressed by the following Expression 1:

   $$(\lambda min/4) \leq p \leq \lambda min \qquad ... (\text{Expression } 1)$$

   where λmin denotes a minimum wavelength of an electromagnetic wave incident on the electromagnetic wave absorber.

4. The electromagnetic wave absorber according to claim 2 or 3, wherein

a height h of the periodic structure from the predetermined plane is expressed by the following Expression 2:

$$h \geq (\lambda max/4) \qquad ... \text{(Expression 2)}$$

where $\lambda$max denotes a maximum wavelength of the electromagnetic wave incident on the electromagnetic wave absorber.

5. The electromagnetic wave absorber according to any one of claims 2 to 4, wherein:

the periodic structure is a hollow conical structure, and
the heat conductive layer provided on the outer surface of the hollow structure, the heat conductive layer provided on an inner surface of the hollow structure, and the heat conductive layer provided on the bottom surface portion are formed so as to be continuous with one another.

6. The electromagnetic wave absorber according to any one of claims 2 to 5, wherein
the periodic structure is a pyramidal structure, and an opening is provided in a side surface of the pyramidal structure.

7. The electromagnetic wave absorber according to any one of claims 2 to 4, wherein
the periodic structure is a columnar structure in which an opening is provided in a bottom surface facing the predetermined plane.

8. The electromagnetic wave absorber according to any one of claims 2 to 4, wherein
the periodic structure is a lattice structure that extends in a direction along the predetermined plane and a height direction.

9. The electromagnetic wave absorber according to claim 1, wherein
the hollow structure is a structure having a spherical shape or a cylindrical shape that internally reflects at least a part of an incident electromagnetic wave, and has an opening through which the electromagnetic wave is caused to enter an interior of the structure.

10. A method of manufacturing an electromagnetic wave absorber, the method comprising:

forming a hollow structure having a bottom surface portion by using a 3D printer; and
continuously forming a heat conductive layer from an outer surface of the hollow structure to the bottom surface portion, wherein
a shaping method using the 3D printer is at least any one of a fused deposition modeling method, a stereolithography method, a powder sintering method, and a material jetting method.

FIG. 1A

FIG. 1B

FIG. 2A

FIG. 2B

FIG. 2C

FIG. 3

FIG. 4A

FIG. 4B

FIG. 5A

FIG. 5B

FIG. 6A

FIG. 6B

FIG. 7A

FIG. 7B

200    201    300

FIG. 8A

ELECTROMAGNETIC WAVE INCIDENCE

201    HEAT ABSORPTION AND DIFFUSION    300

202

FIG. 8B

200    201    300

202

HEAT ABSORPTION AND DIFFUSION

ELECTROMAGNETIC WAVE INCIDENCE

FIG. 8C

FIG. 9

FIG. 10

FIG. 11A

FIG. 11B

FIG. 12

FIG. 13A

FIG. 13B

## COMPARATIVE EXAMPLE 1

FRONT SURFACE                    BACK SURFACE

## FIG. 14A

## SAMPLE 1

FRONT SURFACE                         BACK SURFACE

COPPER FOIL                                                              BLACKBODY
                                                                         SPRAY

## FIG. 14B

FIG. 15

FIG. 16

FIG. 17A

FIG. 17B

FIG. 18

FIG. 19A

FIG. 19B

FIG. 20

FIG. 21

FIG. 22A

FIG. 22B

FIG. 23A

FIG. 23B

FIG. 24A

FIG. 24B

33

| | HEAT CONDUCTIVE LAYER THICKNESS | REFLECTIVITY R@120 GHz $R \leq 1\%$ ◎ $1\% < R \leq 10\%$ ○ $R > 10\%$ × | 90% THERMAL TIME CONSTANT $\gamma$ $\tau \leq 100$秒 ○ $\tau > 100$秒 × |
|---|---|---|---|
| SAMPLE 1 VOLUME $2.6 \times 10^2$ mm$^3$ | N/A | × (90%) | × 190 SEC |
| | 70 nm | ○ (5.8%) | × 180 SEC |
| | 158 nm | ◎ (0.6%) | ○ 100 SEC |
| | 246 nm | × (18.6%) | ○ 100 SEC |
| SAMPLE 2 VOLUME $2.0 \times 10^2$ mm$^3$ | N/A | × (85.1 %) | × 180 SEC |
| | 79 nm | × ( 13.5 %) | × 150 SEC |
| | 132 nm | ◎ (0.48 %) | ○ 100 SEC |
| | 176 nm | ○ (1.7 %) | ○ 100 SEC |
| SAMPLE 3 VOLUME $1.5 \times 10^2$ mm$^3$ | N/A | NOT MEASURED | ○ 90 SEC |
| | 70 nm | × (32%) | ○ 80 SEC |
| | 97 nm | ○ (2.2%) | ○ 60 SEC |
| | 141 nm | ○ (4.3%) | ○ 50 SEC |
| | 185 nm | ○ (7.9%) | ○ 60 SEC |
| SAMPLE 4 VOLUME $2.5 \times 10^2$ mm$^3$ | N/A | NOT MEASURED | × 250 SEC |
| | 53 nm | × (11%) | × 130 SEC |
| | 88 nm | ○ (5%) | ○ 100 SEC |
| | 132 nm | ○ (3.5%) | ○ 100 SEC |
| | 176 nm | ○ (4%) | 100 SEC |
| SAMPLE 5 VOLUME $3.8 \times 10^2$ mm$^3$ | N/A | × (73.3 %) | × 300 SEC |
| | 53 nm | × (40 %) | × 200 SEC |
| | 106 nm | ○ (5.5 %) | NOT MEASURED |
| | 158 nm | ◎ (0.3 %) | × 180 SEC |
| COMPARATIVE EXAMPLE 1 MAGNETIC-LOSS EPOXY PYRAMID VOLUME $3.8 \times 10^2$ mm$^3$ | | ◎ (0.5%) | × 300 SEC |

FIG. 25

## INTERNATIONAL SEARCH REPORT

| International application No. |
|---|
| **PCT/JP2024/023334** |

**A.    CLASSIFICATION OF SUBJECT MATTER**

*H05K 9/00*(2006.01)i; *B22F 10/00*(2021.01)i; *B29C 64/112*(2017.01)i; *B29C 64/118*(2017.01)i; *B29C 64/124*(2017.01)i; *B29C 64/153*(2017.01)i; *B33Y 10/00*(2015.01)i; *B33Y 40/20*(2020.01)i; *G01J 1/02*(2006.01)i; *H01Q 17/00*(2006.01)i
FI:    H05K9/00 M; H01Q17/00; B29C64/112; B29C64/118; B29C64/124; B29C64/153; B33Y10/00; B33Y40/20; G01J1/02 K; G01J1/02 F; B22F10/00

According to International Patent Classification (IPC) or to both national classification and IPC

**B.    FIELDS SEARCHED**

Minimum documentation searched (classification system followed by classification symbols)

H05K9/00; B22F10/00; B29C64/112; B29C64/118; B29C64/124; B29C64/153; B33Y10/00; B33Y40/20; G01J1/02; H01Q17/00

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C.    DOCUMENTS CONSIDERED TO BE RELEVANT**

| Category* | Citation of document, with indication, where appropriate, of the relevant passages | Relevant to claim No. |
|---|---|---|
| Y | JP 3-69197 A (INTERNATL TECHNO RES KK) 25 March 1991 (1991-03-25) publication gazette, p. 2, upper right column, line 12 to lower left column, line 14, fig. 1 | 1-2, 6, 10 |
| A | | 3-5, 7-9 |
| Y | JP 3243042 U (LAIRD TECHNOLOGIES, INC.) 31 July 2023 (2023-07-31) paragraphs [0009]-[0013], [0038], [0136], fig. 1-3 | 1-2, 6, 10 |
| Y | JP 2009-177105 A (MATSUOKA ROOFING INC.) 06 August 2009 (2009-08-06) paragraph [0020], fig. 7 | 6 |
| A | JP 2002-328143 A (ATR KANKYO TEKIO TSUSHIN KENKYUSHO KK) 15 November 2002 (2002-11-15) | 1-10 |
| A | JP 2022-157654 A (E & C ENGINEERING K.K.) 14 October 2022 (2022-10-14) | 1-10 |

☑ Further documents are listed in the continuation of Box C.          ☑ See patent family annex.

| | |
|---|---|
| *     Special categories of cited documents:<br>"A"   document defining the general state of the art which is not considered to be of particular relevance<br>"D"   document cited by the applicant in the international application<br>"E"   earlier application or patent but published on or after the international filing date<br>"L"   document which may throw doubts on priority claim(s) or which is cited to establish the publication date of another citation or other special reason (as specified)<br>"O"   document referring to an oral disclosure, use, exhibition or other means<br>"P"   document published prior to the international filing date but later than the priority date claimed | "T"   later document published after the international filing date or priority date and not in conflict with the application but cited to understand the principle or theory underlying the invention<br>"X"   document of particular relevance; the claimed invention cannot be considered novel or cannot be considered to involve an inventive step when the document is taken alone<br>"Y"   document of particular relevance; the claimed invention cannot be considered to involve an inventive step when the document is combined with one or more other such documents, such combination being obvious to a person skilled in the art<br>"&"   document member of the same patent family |

| Date of the actual completion of the international search | Date of mailing of the international search report |
|---|---|
| **28 August 2024** | **10 September 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (July 2022)

**INTERNATIONAL SEARCH REPORT**

International application No.

**PCT/JP2024/023334**

| C. | DOCUMENTS CONSIDERED TO BE RELEVANT | |
|---|---|---|
| Category* | Citation of document, with indication, where appropriate, of the relevant passages | Relevant to claim No. |
| A | JP 2005-12031 A (TDK CORPORATION) 13 January 2005 (2005-01-13) | 1-10 |
| A | JP 2001-244686 A (TDK CORP.) 07 September 2001 (2001-09-07) | 1-10 |

Form PCT/ISA/210 (second sheet) (July 2022)

### INTERNATIONAL SEARCH REPORT
**Information on patent family members**

International application No.

**PCT/JP2024/023334**

| Patent document cited in search report | | | Publication date (day/month/year) | Patent family member(s) | Publication date (day/month/year) |
|---|---|---|---|---|---|
| JP | 3-69197 | A | 25 March 1991 | (Family: none) | |
| JP | 3243042 | U | 31 July 2023 | US 2020/0253096 A1 paragraphs [0064]-[0068], [0093], [0174], fig. 1A-3 WO 2020/041320 A1 DE 202019005902 U1 KR 10-2021-0033059 A CN 112585541 A | |
| JP | 2009-177105 | A | 06 August 2009 | (Family: none) | |
| JP | 2002-328143 | A | 15 November 2002 | (Family: none) | |
| JP | 2022-157654 | A | 14 October 2022 | (Family: none) | |
| JP | 2005-12031 | A | 13 January 2005 | (Family: none) | |
| JP | 2001-244686 | A | 07 September 2001 | (Family: none) | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2022032341 A
- JP 2014187134 A
- JP 5606572 B
- JP 2015095638 A
- JP 6877770 B
- JP 2023133366 A

**Non-patent literature cited in the description**

- **L. N. HADLEY ; D. M. DENNISON**. *J. Opt. Soc. Am.*, 1947, vol. 37, 451
- **H. IIDA et al.** *J. Infrared Milli. Terahz. Waves*, 2018, vol. 39 (5)